## Europäisches Patentamt
## European Patent Office
## Office européen des brevets

(11) Publication number: **0 047 673**
**B1**

# EUROPEAN PATENT SPECIFICATION

(45) Date of publication of patent specification: **02.05.85**

(51) Int. Cl.⁴: **H 02 H 3/26,** G 01 R 25/00

(21) Application number: **81304118.3**

(22) Date of filing: **09.09.81**

(54) **Phase discriminator circuit.**

(30) Priority: **10.09.80 JP 125810/80**

(43) Date of publication of application:
**17.03.82 Bulletin 82/11**

(45) Publication of the grant of the patent:
**02.05.85 Bulletin 85/18**

(84) Designated Contracting States:
**CH GB LI SE**

(56) References cited:
**CH-B- 576 716**
**DE-A-1 951 146**
**DE-A-2 022 231**
**US-A-4 053 940**
**US-A-4 225 795**

(73) Proprietor: **MITSUBISHI DENKI KABUSHIKI KAISHA**
**2-3, Marunouchi 2-chome Chiyoda-ku**
**Tokyo 100 (JP)**

(72) Inventor: **Suzuki, Sunao**
**20-8, Koyo-cho, Kita-ku**
**City of Kobe Hyogo Prefecture (JP)**
Inventor: **Kotani, Genzaburou**
**5-1-601, Oakashi-cho 2-chome**
**City of Akashi Hyogo Prefecture (JP)**

(74) Representative: **Messulam, Alec Moses et al**
**MARKS & CLERK 57/60 Lincoln's Inn Fields**
**London WC2A 3LS (GB)**

Courier Press, Leamington Spa, England.

## Description

This invention relates to a phase discriminator circuit for connection to a power system to protect the system equipment.

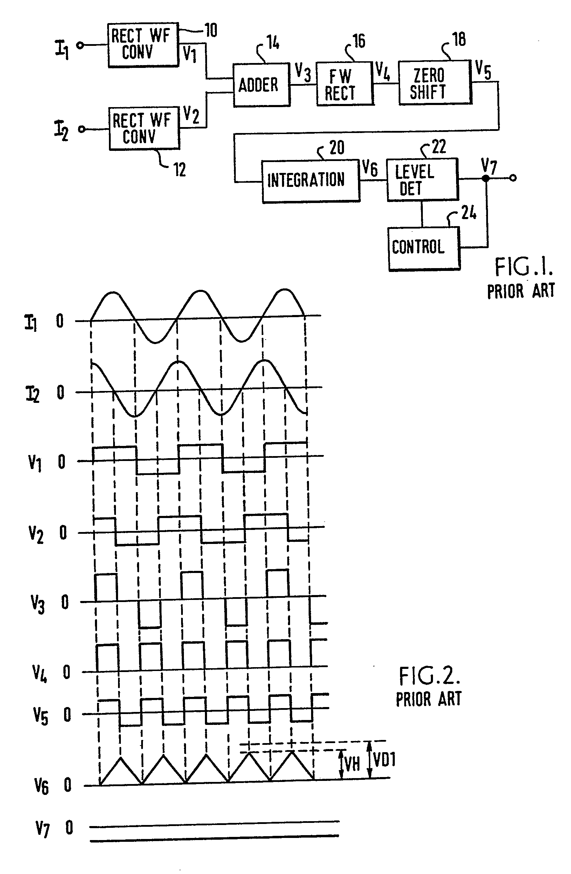

A known phase discriminator circuit is shown in Figure 1 and will now be described with the aid of the waveform diagrams shown in Figures 2 to 6.

The arrangement illustrated in Figure 1 comprises first and second converter circuits 10 and 12 respectively for converting a first and a second AC electric input $I_1$ and $I_2$ to corresponding rectangular waveforms $V_1$ and $V_2$ respectively, an adder circuit 14 for adding the rectangular waveforms $V_1$ and $V_2$ from the first and second converter circuits 10 and 12 to each other to form the sum $V_3$ thereof, and a full-wave rectifier circuit 16 for full-wave rectifying the sum $V_3$ of the rectangular waveforms $V_1+V_2$ into a full-wave rectified voltage $V_4$. The arrangement comprises further a circuit 18 for shifting the zero voltage point that is to say the mean DC level, of the voltage $V_4$ from the full-wave rectifier circuit 16, an integration circuit 20 for integrating the DC adjusted voltage $V_5$ from the circuit 18 hereinafter termed a zero shifting circuit, and a level detector circuit 22 for detectimg the level of the integrated voltage $V_6$. In use, the level detector circuit 22 produces a first signal, herein termed an operating signal, in response to the integrated voltage $V_6$ having a level not less than a first threshold level and a second signal, termed an inoperative signal, in response to the voltage $V_6$ dropping below a rest threshold level. A control circuit 24 is connected to the level detector circuit 22 to determine whether the output voltage $V_7$ from the level detector circuit 22 corresponds to the operating or inoperative signal and controls the threshold level of the circuit 22 accordingly. The threshold level has a value $V_{D1}$ when the level detector circuit 22 produces an inoperative signal 24 and has a rest value $V_{D2}$, lower than $V_{D1}$, when the level detector circuit 22 produces an operating signal.

The arrangement of Figure 1 discriminates the phase relationship between the first and second AC inputs $I_1$ and $I_2$ respectively so that the inoperative signal is produced when the phase difference therebetween is not less than 90 degrees and the operative signal is produced when that phase difference is less than 90 degrees.

The operation of the arrangement shown in Figure 1 will now be described in conjunction with Figures 2, 3 and 4 wherein there are illustrated waveforms developed at various points in the arrangement put at its operating limit, in its operative state and in its operating state respectively. Waveforms shown in each of Figures 2, 3 and 4 are designated by like reference characters suffixed with the reference numerals identifying the corresponding currents and output voltages shown in Figure 1. For example, $I_1$ designates waveform of the first AC input $I_1$ in the form of a current applied to the first rectangular waveform converter circuit 10 and $V_1$ designates waveform of the output $V_1$ from the converter circuit 10.

in Figure 2 the first and second AC inputs $I_1$ and $I_2$ have a phase difference of 90 degrees therebetween. As described above, those AC inputs $I_1$ and $I_2$ are applied to the first and second converter circuits 10 and 12 to be converted to the first and second rectangular waveforms $V_1$ and $V_2$ respectively. As shown at waveform $V_1$ or $V_2$ in Figure 2, the positive portion of each AC input is converted to a positive rectangular waveform portion while the negative portion thereof is converted to a negative rectangular waveform portion with both waveform portions equal in amplitude to each other.

The adder circuit 14 adds the first waveform $V_1$ to the second waveform $V_2$ to produce the sum of those waveforms including positive rectangular waveform portions alternating with negative rectangular waveform portions with an equal time interval formed between each pair of positive and negative rectangular waveform portions as shown at waveform $V_3$ in Figure 2. Then the sum $V_3$ from the adder circuit 14 is full-wave rectified into the rectified voltage $V_4$ (see waveform $V_4$, Figure 2) by the full-wave rectifier circuit 16. Then the rectified voltage $V_4$ is subjected to a zero shift in the zero shifting circuit 18. The resulting zero shifted voltage $V_5$ is shown at waveform $V_5$ in Figure 2 as including positive rectangular waveform portion alternating with negative rectangular waveform portions and equal in amplitude to the latter. Also each positive rectangular waveform portion corresponds to the time interval during which the first AC input $I_1$ has the same polarity as the second AC input $I_2$, while each negative rectangular waveform portion is developed for the time interval during which the AV input $I_1$ and $I_2$ have opposite polarity. As Figure 2 shows, a phase difference of 90 degrees between the first and second AC inputs $I_1$ and $I_2$ results in the positive rectangular waveform portion from the zero shifting circuit 18 being equal in duration to the negative waveform portion therefrom.

Waveform $V_6$ shows the output voltage $V_6$ from the integration circuit 20 resulting from the integration of the zero shifting voltage $V_5$ produced by the zero shifting circuit 18. Assuming now that the integration circuit 20 has a time constant during charge equal to that during discharge, the output voltage $V_6$ from the integration circuit 20 is in the form of triangular waveforms as shown at waveform $V_6$ in Figure 2. This is because the positive rectangular waveform portions from the zero shifting circuit 18 is equal in both duration and amplitude to the negative rectangular waveform portion therefrom as described above.

It is now assumed only for convenience of the succeeding description that $V_H$ designates the integrated value to which the integration circuit 20 is charged for a time interval for which the phase of the first AC input $I_1$ changes from its zero to its 90 degrees and which is discharged by the integration circuit 20 and for the next succeeding interval equal to that described above. The value $V_H$ may be called hereinafter the integrated value for the phase of 90 degrees.

The level detector circuit 22 has the above-mentioned operation sensing level $V_{D1}$ which is, in turn, preset to be higher than the integrated value $V_H$ (see waveform $V_6$, Figure 2). In the example illustrated as the output voltage $V_6$ from the integration circuit 20 never exceeds the integrated value $V_H$, the output voltage $V_7$ from the level detector circuit 22 is at a negative level as the inoperative signal as shown at waveform $V_7$ in Figure 2.

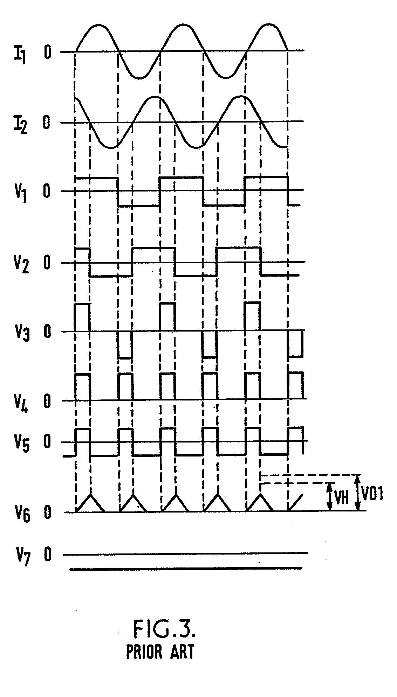

Figure 3 shows waveforms obtaining in the arrangement of Figure 1 where the phase difference between the first and second AC inputs $I_1$ and $I_2$ is more than 90 degrees (see waveforms $I_1$ and $I_2$, Figure 3). Waveforms $V_1, V_2, V_3, V_4$ and $V_5$ shown in Figure 3 are derived in the same manner as described above in conjunction with Figure 2.

Waveform $V_6$ shown in Figure 3 designates also the output voltage $V_6$ from the integration circuit 20. In Figure 3, the time interval for which the first AC input signal $I_1$ is identical in polarity with the second AC input signal $I_2$ is shorter than the time interval for which the two signals $I_1$ and $I_2$ are opposite in polarity to each other so that the integration circuit 20 is charged for less time than it is discharged. Thus the output voltage $V_6$ from the integration circuit 20 does not reach the operation detecting level $V_{D1}$ (see at waveform $V_6$, Figure 3) resulting in the level detector circuit 22 delivering the inoperative signal with a negative level as shown at waveform $V_7$ in Figure 3.

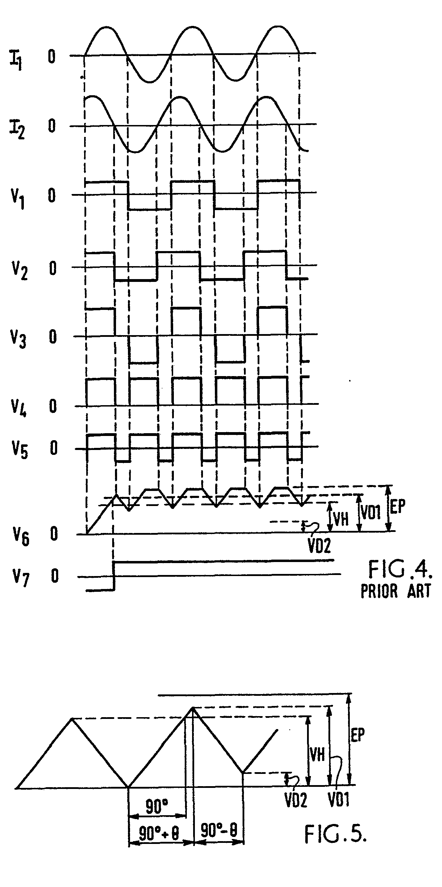

Figure 4 shows the waveforms obtaining in the arrangement of Figure 1 when the phase difference between the two AC inputs $I_1$ and $I_2$ is less than 90 degrees (see waveforms $I_1$ and $I_2$, Figure 4). Waveforms $V_1, V_2, V_3, V_4$ and $V_5$ are derived in the same manner as in the case of Figure 2.

In Figure 4 waveform $V_6$ designates similarly the output voltage $V_6$ from the integration circuit 20 but it reaches at least the operation sensing level $V_{D1}$ and is shown at waveform $V_6$ as exceeding the level $V_{D1}$. This is because the time interval of the two AC input signals $I_1$ and $I_2$ having similar polarity is longer than that of their having dissimilar polarity and therefore the integration circuit 20 is charged for a longer time than it is discharged. As a result, the level detector circuit 22 delivers the output voltage $V_7$ at its positive level as shown at waveform $V_7$ in Figure 4. In other words, the operating signal is developed as the output voltage $V_7$.

It is now assumed that the control circuit 24 is omitted from the arrangement of Figure 1. Under the assumed conditions the output voltage $V_6$ from the integration circuit 20 reaches the operation sensing level $V_{D1}$ once to permit the level detector circuit 22 to deliver the operating signal. However during the next succeeding discharge time the integrated output voltage $V_6$ decreases to a level less than the operation sensing level $V_{D1}$.

Thus the arrangement of Figure 1 without the control circuit 24 would be put back in its inoperative state. This would result in the operating and inoperative signals being repeated in alternating succession.

The control circuit 24 varies the threshold level of the level detector circuit 22 in dependence upon the prevailing output signal so to prevent rapid changes of state by introducing hysteresis.

The repetition of the operating and inoperative signals has been described in conjunction with a transition from the inoperative to the operating state but the same occurs similarly during the transition from the operating to the inoperative state. More specifically, when the output voltage $V_6$ from the integration circuit 20 drops to less than the reset level, detector 22 is reset and this would result also in the phenomenon of the operating and inoperative signals being repeated in succession. Under these circumstances, the control circuit 24 is responsive to the inoperative signal from the level detector circuit 22 to raise the threshold level of the latter circuit to the operation detecting level $V_{D1}$ thereby to prevent the repetition of the operating and inoperative signal.

Figure 5 shows a first and a second integrated waveform from the integration circuit 20 with a phase difference between the two AC inputs greater than 90 degrees and also describes the relationship between the detecting levels of the level detector circuit 22 and the dynamic range of the control circuit 24. As shown in Figure 5, the control circuit has a voltage thereacross ranging from 0 to $E_p$ in volts. The first wave of the output voltage $V_6$ from the integration circuit 20 is in the form of an equilateral triangle with its vertex having the integrated value $V_H$ at the phase of 90 degrees like the waveform $V_6$ shown in Figure 2. The second wave from the integration circuit 20 reaches the operation detecting level $V_{D1}$ at the end of a second charge time corresponding to a phsae interval of $(90+\theta)$ degrees and the reset detecting level $V_{D2}$ at the end of the next succeeding discharge time corresponding to a phase interval of $(90-\theta)$ degrees.

The reset detecting level $V_{D2}$, the integrated value $V_H$ at the phase of 90 degrees, the operation detecting level $V_{D1}$ and the voltage $E_P$ across the control source are required to fulfill the rela-tionship

$$0 < V_{D2} < V_H < V_{D1} < E_P$$

as shown in Figure 5 and for the following reasons:

1) As the integrated value has its upper limit equal to the source voltage $E_P$, the integration circuit 20 is required to have a time constant as determined so as not to render $V_H$ higher than $E_P$.

2) If the operation detection cannot be performed upon the upper limit of the integrated value reaching $E_P$ then the meaning of the operation detection is lost. Therefore $V_{D1}$ is neces-sarily less than $E_P$. This is because $V_{D1}$ is required to be preliminarily less than $E_P$ in order to prevent the detection from being disabled upon the integrated value reaching $E_P$ due to a change in temperature of each of the particular electronic components which determine set values of the detecting levels.

3) It is required to render $V_{D2}$ higher than the lower limit 0 volt of the source voltage for the same reason as described above in Item 2). That is, if the reset detection cannot be effected upon the integrated value reaching 0 volt then the meaning of the reset sensing is lost.

4) It is required to render the value of the operation detecting level $V_{D1}$ higher than the integrated value $V_H$ by a value equal to one half the difference between $V_{D2}$ and 0 for the following reasons:

It is assumed that, due to the occurrence of a fault the time interval of the two AC input signal $I_1$ and $I_2$ having the similar polarity is longer than that of their having dissimilar polarity and corresponds, for example, to a phase interval of $(90+\theta)$ degrees greater than 90 degrees and the operation detecting level $V_{D1}$ is reached at the phase of $(90+\theta)$ degrees relative to the phase of the initiation of the integration. Under the assumed conditions,

$$V_{D1} = \frac{90+\theta}{90} \cdot V_H \qquad (1)$$

holds because the integrated value at the phase of 90 degrees is $V_H$. Then a time interval of the dissimilar polarity is entered and the discharge is effected for a time interval corresponding to a phase interval of $(90-\theta)$ degrees. As a result, the discharge quantity at that time may be expressed by

$$\frac{90-\theta}{90} \cdot V_H$$

Thus the integrated value y after one half cycle of the AC input may be expressed by

$$y = V_{D1} - \frac{90-\theta}{90} \cdot V_H \qquad (2)$$

Substituting the expression (1) into the expression (2), results in

$$y = 2(V_{D1} - V_H) \qquad (3)$$

When the operation detecting level $V_{D1}$ is reached with the phase difference of $(90+\theta)$ degrees between the two AC inputs $I_1$ and $I_2$, the reached level is a limit of the operation. Thus it is required to make y equal to $V_{D2}$ so that the reset detecting level has a limit value as defined by the integrated value after the discharge. Accordingly by substituting $V_{D2}$ for y in the expression (3),

$$V_{D1} = \frac{V_{D2}}{2} + V_H \qquad (4)$$

is obtained. Therefore it is seen that the reset detecting level $V_{D1}$ should be set to be higher than $V_H$ by $V_{D2}/2$.

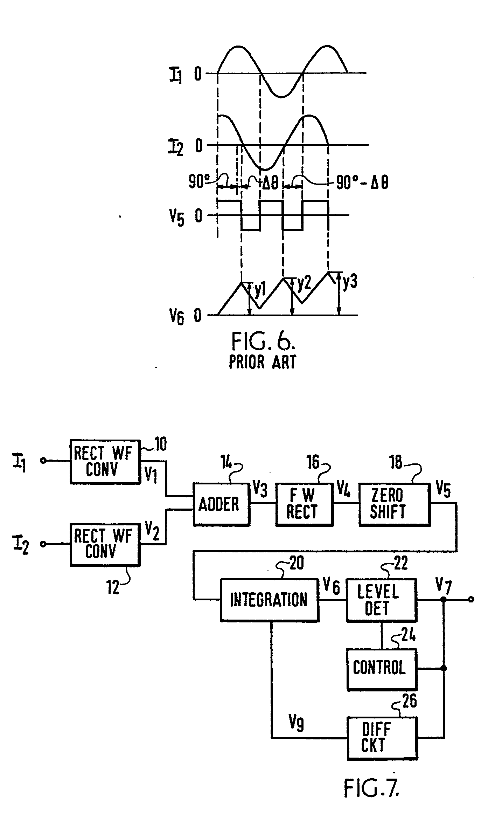

Figure 6 is a graph useful in explaining the disadvantages of conventional integrating phase discriminator circuits such as described above in conjunction with Figures 1, 2, 3, 4 and 5. Figure 6 describes the time delay with which the operation detection is effected. That time delay is caused by the fact that the operation detecting level $V_{D1}$ is higher than the integrated value $V_H$ by $V_{D2}/2$ as described above in conjunction with Figure 5.

When the two AC input signals $I_1$ and $I_2$ have the similar polarity for a time interval corresponding to the phase interval of $(90+\Delta\theta)$ degrees as shown at waveforms $I_1$ and $I_2$ in Figure 6, the output voltage $V_5$ from the zero shifting circuit 18 includes positive rectangular waveforms having their duration equal to the phase interval of $(90+\Delta\theta)$ degrees as shown at waveform $V_5$ in Figure 6. Therefore the integrated value $y_1$ due to a first charge may be expressed by

$$y_1 = \frac{90+\Delta\theta}{90} \times V_H$$

and the second integrated value $y_2$ may be expressed by

$$y_2 = y_1 - \frac{90-\Delta\theta}{90} \cdot V_H + \frac{90+\Delta\theta}{90} \cdot V_H$$

$$= \{1 + \frac{3\Delta\theta}{90}\} \cdot V_H$$

Similarly the integrated value $y_n$ due to the n-th charge may be expressed by

$$y_n = \{1 + \frac{(2n-1)\Delta\theta}{90}\} \cdot V_H$$

The integrated value $y_n$ is gradually increased with n as seen from waveform $V_6$ shown in Figure 6. When the integrated value $y_n$ reaches the operation detecting level $V_{D1}$, the level detector circuit 22 provides the operating signal. Thus

$$\{1 + \frac{(2n-1)\Delta\theta}{90} \cdot V_H = V_{D1}$$

is obtained. By substituting the expression (4) into the above expression, n is given by

$$n = \frac{45V_{D2}}{2\Delta\theta \cdot V_H} + \frac{1}{2}$$

From the foregoing it is seen that, for a very small $\Delta\theta$, n charges are effected until the integrated value reaches the operation detecting level $V_{D1}$ after having exceeded $V_H$. In other words, n/2 cycles of the AC input lapse till the integrated value reaches $V_{D1}$.

Also when the integrated value is changed from the operating state corresponding to the upper limit $E_P$ to the inoperative state to render the discharged quantity greater than a corresponding charged quantity, time goes by till the resetting as in the case the integrated value reaches the operation sensing level. This is because when the two AC inputs have a phase difference approximating an angle of 90 degrees, the time interval of their having the dissimilar polarity corresponds to $(90+\Delta\theta)$ degrees.

Therefore conventional integrating phase discriminator circuits such as shown in Figure 1 have been disadvantageous in that the operation and the reset detecting time points are delayed.

The present invention seeks to provide a phase discriminator circuit with a fast response time.

According to the present invention, there is provided a phase discriminator circuit comprising an integration circuit for effecting a positive integration when a first and a second AC quantity are identical (or opposite) in polarity to each other and effecting a negative integration when the first and second AC quantities are opposite (or identical) in polarity to each other, a level detector circuit having a first and a second detection level and responsive to the output of the integration circuit reaching the first detection level to render the detector circuit output positive (or negative) and to change the detection level to the second detection level, the level detector circuit being responsive to the output of the integration circuit reaching the second detection level to render the detector circuit output negative (or positive) and to change the detection level to the first detection level, characterized in that it comprises a differentiation circuit for changing the output of the integration circuit to an upper limit (or a lower limit) at the instant when the output of the level detector circuit changes from its negative to its positive magnitude and for changing the output of the integration circuit to the lower limit (or the upper limit) at the instant when the output of the level detector circuit changes from its positive to its negative magnitude.

The invention will now be described further, by way of example, with reference to the accompanying drawings, in which:

Figure 1 is as previously described, a block circuit diagram of a known phase discriminator,

Figures 2 to 6 are waveform diagrams explaining the operation of the discriminator of Figure 1,

Figure 7 is a block diagram of a discriminator of the invention,

Figure 8 shows in greater detail the integration and differentiation circuits in Figure 7 and

Figures 9 and 10 are waveform diagrams for explaining the operation of the circuit in Figure 7.

Referring now to Figure 7 wherein like reference numerals designate components identical to those shown in Figure 1, there is illustrated one embodiment of the phase discriminator circuit of the present invention. The arrangement illustrated is different from that shown in Figure 1 in that in Figure 7 a differentiation circuit 26 is connected at the output to the integration circuit 20 and at the input to both the level detector circuit 22 and the control circuit 24. The differentiation circuit 26 responds to a change of state of the output of the detector circuit 22 to generate a pulse to raise or lower the integrated value from the integration circuit 20 to the upper or lower limit of the integrated quantity.

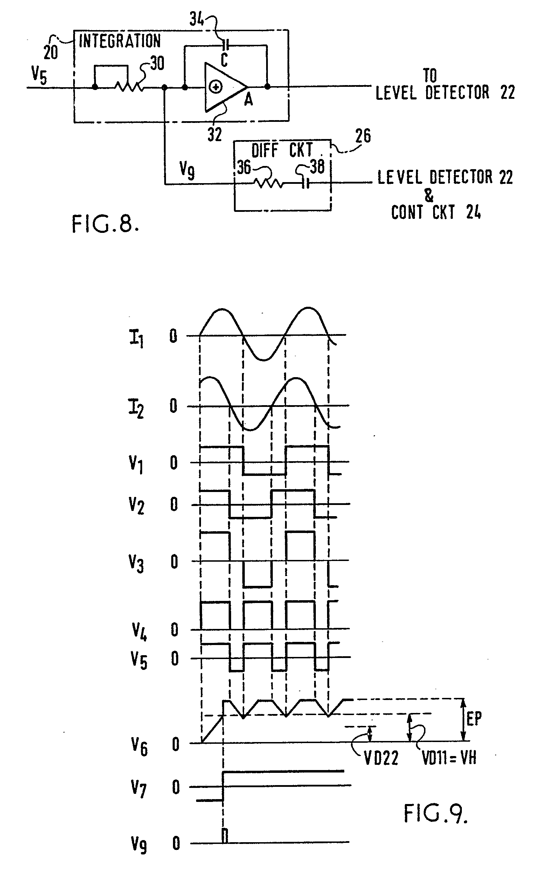

Figure 8 is a circuit diagram of the details of both integration and differentiation circuits 20 and 26. The integration circuit 20 includes a variable input resistor 30 connected to the output of the zero shifting circuit 18 (not shown), an operational amplifier 32 and a feedback capacitor 64 connected across the output and input of the operational amplifier 32. The differentiation circuit 26 including a series combination of a resistor 36 and a capacitor 38 with the resistor 36 connected to the input to the operation amplifier 32 and the capacitor 38 connected to both the output of the level detector circuit 22 and the input to the control circuit 23.

The differentiation circuit 26 differentiates the output voltage $V_7$ from the level detector circuit 22 and applies a differentiated pulse to the input to the operational amplifier 32.

The operational amplifier 32 is responsive to a positive pulse from the differentiation circuit 26 to cause immediately its output to reach the upper limit $E_P$ und is responsive to a negative pulse from the differentiation circuit to render its output immediately null.

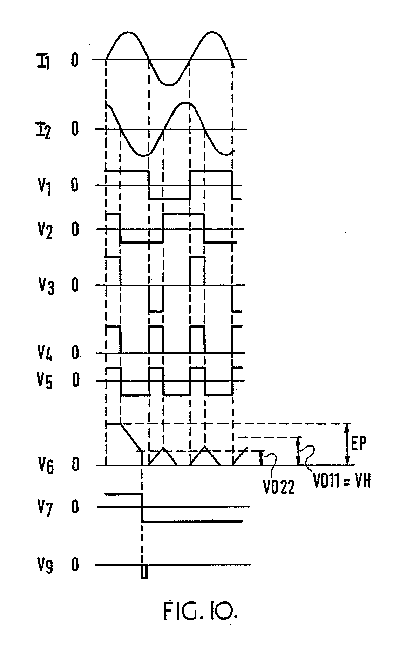

The operation of the arrangement shown in Figure 7 will now be described in conjunction with Figures 9 and 10. Figure 9 illustrates waveforms developed at the same points as those shown in Figure 2, 3 or 4 and at the output of the differentiation circuit 26 in the arrangement of Figure 7 put in the operating state and Figure 10 shows waveforms similar to those illustrated in Figure 9 but illustrates the arrangement of Figure 7 put in the inoperative state.

Thus Figure 9 corresponds to Figure 4 and shows waveforms $I_1$ and $I_2$ for the first and second AC inputs $I_1$ and $I_2$ having a phase difference of less than 90 degrees therebetween. Also waveforms $V_1, V_2, V_3, V_4$ and $V_5$ shown in Figure 9 are developed in the manner as described above in conjunction with Figures 2 and 4. Also waveform $V_6$ is similar to that shown in Figure 4 excepting that in Figure 9 the level detector circuit 22 has the operation detecting level $V_{D11}$ equal to the integrated value $V_H$ at the phase of 90 degrees from the integration circuit 20. Accordingly, the level detector circuit 22 delivers the output voltage $V_7$ forming the operating signal at the instant the integrated value $V_6$ reaches the

operation sensing level $V_{D11}$ (see waveforms $V_6$ and $V_7$, Figure 9).

On the other hand, the differentiation circuit 26 is responsive to the transition of the inoperative or negative signal to the operating or positive signal to generate a positive differentiated pulse as shown at waveform $V_9$ in Figure 9. The positive pulse $V_9$ is applied to the input of the operational amplifier 32 in the integration circuit 20 with the result that the output voltage $V_6$ from the integration circuit 20 is forcibly raised from the integrated value $V_{D11}$ to its upper limit $E_P$ as shown at waveform 6 in Figure 9.

Also as the level detector circuit 22 delivers the operating signal, the control circuit 24 controls the same to set its threshold level to the reset detecting level $V_{D22}$ which is, in turn, equal to the discharge integrated value $V_H$ at the phase of 90 degrees subtracted from the upper limit $E_P$ or $E_P - V_H$. This results in the level detector circuit 22 continuously delivering the operating signal as shown at waveform $V_7$ in Figure 9.

Since the level detector circuit 22 has the operation detecting level $V_{D11}$ equal to $V_H$ it is seen that the operation is performed at a high speed without any time delay.

Figure 10 illustrates the inoperative state of the arrangement shown in Figure 7 because the two AC inputs $I_1$ and $I_2$ have a phase difference of more than 90 degrees therebetween (see waveforms $I_1$ and $I_2$, Figure 10) and therefore corresponds to Figure 3. In Figure 10 waveforms $V_1$, $V_2$, $V_3$, $V_4$ and $V_5$ are developed in the manner described above in conjunction with Figure 3. Waveform $V_6$ shown in Figure 10 illustrates that the output voltage from the integration circuit 20 reaches the reset detecting level $V_{D22}$ to change the output voltage $V_7$ from the level detector circuit 22 from the operating to the inoperative signal. This is because the two AC inputs $I_1$ and $I_2$ have opposite polarity for a longer duration than they have similar polarity to render the charged quantity greater than the discharged quantity from the integration circuit 20.

The differentiation circuit 28 generates a negative differentiated pulse (see waveform $V_9$, Figure 10) in response to the transition of the operating or positive to the inoperative or negative signal from the level detector circuit 22. The negative pulse shown at waveform $V_9$ in Figure 10 is applied to the input to the operational amplifier 32 in the integration circuit 20 to lower forcibly the output voltage $V_6$ from the integrated value $V_{D22}$ to the lower limit 0 volt. Also as the level detector circuit 22 delivers now a resetting signal, the control circuit 24 is operated to make the threshold level of the level detector circuit 22 to the operation sensing level $V_{D11}$ resulting in the level detector circuit 22 continuously delivering the resetting signal (see waveform $V_7$, Figure 10).

As the reset detecting level $V_{D22}$ is equal to the integrated value $V_H$ at the phase of 90 degrees but not to the upper limit $E_P$, it is seen that the reset is effected at a high speed without any time delay.

In summary, the present invention comprises a differentiation circuit for differentiating a change in output from the level detector circuit resulting from an integrated value from an integration circuit reaching the operation or reset detecting level and feeding the resulting pulse back to the integration circuit. Therefore the present invention gives the great result that the operation and reset can be performed without any time delay required unavoidably for the prior art practice.

In addition, the present invention is advantageous in that the detecting ability has a tolerance, although it depends upon a change in temperature, because the difference between the upper limit $E_P$ and the operating threshold level $V_{D11}$ can be set to be greater than the corresponding difference previously used. This is evident from the fact that, by substituting $(E_P - V_{D11})$ according to the present circuits and $(E_P - V_{D1})$ according to conventional circuits into the expression (4) respectively and comparing them with each other,

$$(E_P - V_{D11}) - (E_P - V_{D1}) = (E_P - V_H) -$$

$$(E_P - \frac{V_{D2}}{2} - V_H) = \frac{V_{D2}}{2}$$

yields and describes that $(E_P - V_{D11})$ is greater than $(E_P - V_{D1}$ by $V_{D2}/2$. Also the comparison of the reset detecting level $V_{D2}$ with the lower limit 0 volt offers a proof that the present circuit is greater in tolerance than the conventional circuits.

In conventional circuits the meaning of the reset detection is lost in the case the reset detecting level $V_{D2}$ cannot be detected upon the resetting due to a change in temperature. Therefore a difference of $V_{D2}$ has been given. Like this a tolerance expressed by $E_P - V_{D1} = V_{D2}$ has been set with respect to the upper limit $E_P$ so that the operation detecting level $V_{D1}$ can be detected upon the operation even though the temperature would change. Substituting $V_{D2}$ into the expression (4) results in

$$V_{D2} = \tfrac{2}{3}(E_P - V_H)$$

On the other hand, the present invention uses the reset detecting level $V_{D22}$ expressed by $V_{D22} = E_P - V_H$. Therefore

$$V_{D22} - V_{D2} = \tfrac{1}{3}(E_P - V_H)$$

indicates a difference in tolerance between the circuit of the present invention and conventional circuits which is certainly greater than zero.

The present invention is applicable to relays for discriminating predetermined phases, for example ground fault directional relays and distance relays. For ground fault directional relays, the first and second AC inputs $I_1$ and $I_2$ as described above are formed of the zero phase sequence current and voltage respectively. Also for distance relays, the first AC input $I_1$ comprises

the calculated voltage and the second AC input signal $I_2$ comprises the reference voltage.

While the present invention has been described in conjunction with means for converting the first and second AC inputs to respective rectangular waveforms, adding the rectangular waveforms to each other and full-wave rectifying the sum of the rectangular waveforms it is to be understood that those means may be replaced by means for sensing the similar or dissimilar polarity of the first and second AC inputs followed followed by their application to zero shifting circuit.

## Claim

A phase discriminator circuit comprising an integration circuit (20) for effecting a positive integration when a first and a second AC quantity ($I_1$, $I_2$) are identical (or opposite) in polarity to each other and effecting a negative integration when the first and second AC quantities are opposite (or identical) in polarity to each other, a level detector circuit (22) having a first and a second detection level ($V_{D11}$, $V_{D22}$) and responsive to the output of the integration circuit reaching the first detection level ($V_{D11}$) to render the detector circuit output positive (or negative) and to change the detection level to the second detection level, the level detector (22) circuit being responsive to the output of the integration circuit reaching the second detection level ($V_{D22}$) to render the detector circuit output negative (or positive) and to change the detection level to the first detection level ($V_{D11}$), characterized in that it comprises a differentiation circuit (26) for changing the output of the integration circuit (20) to an upper limit or a lower limit) at the instant when the output of the level detector circuit (22) changes from is negative to its positive magnitude and for changing the output of the integration circuit (20 to the lower limit (or the upper limit) at the instant when the output of the level detector circuit (22) changes from its positive to its negative magnitude.

## Patentanspruch

Phasendetektorschaltung mit einer Integrationsschaltung (20) zum Durchführen einer positiven Integration wenn eine erste une eine zweite Wechselstromgröße ($I_1$, $I_2$) identische (oder entgegengesetzte) Polarität zueinander aufweisen und zum Durchführen einer negativen Integration, wenn die erste und zweite Wechselstromgröße entgegengesetzte (oder identische) Polarität zueinander aufweisen, mit einer Pegeldetektorschaltung (22), die einen ersten und einen zweiten Detektorpegel ($V_{D11}$, $V_{D22}$) aufweist und auf den Ausgang der Integrationsschaltung anspricht, die den ersten Detektorpegel ($V_{D11}$) erreicht um den Ausgang der Detektorschaltung positiv (oder negative) zu schalten und den Detektorpegel auf den zweiten Detektorpegel zu ändern, wobei die Pegeldetektorschaltung (22) auf den Ausgang der Integrationsschaltung anspricht und die den zweiten Detektorpelel ($V_{D22}$) erreicht um den Ausgang der Detektorschaltung negativ(oder positiv) zu schalten und den Detektorpegel auf den ersten Detektorpegel ($V_{D11}$) zu ändern, dadurch gekennzeichnet, daß sie eine Differentiationsschaltung (26) aufweist zur Änderung des Ausgangs der Integrationsschaltung (20) auf einen oberen Grenzwert (oder unteren Grenzwert) zu dem Zeitpunkt, zu dem der Ausgang der Pegeldetektorschaltung (22) von seinem negativen zu seinem positiven Wert wechselt und zum Ändern des Ausgangs der Integrationsschaltung (20) zu einem unteren Grenzwert (oder oberen Grenzwert) zu dem Zeitpunkt, zu dem der Ausgang der Pegeldetektorschaltung (22) von seinem positiven zu seinem negativen Wert wechselt.

## Revendication

Comparateur de phase comprenant un circuit intégrateur (20) pour effectuer une intégration positive lorsqu'une première et une seconde quantité en courant alternatif ($I_1$, $I_2$) ont des polarities identiques (ou opposées) et une intégration négative lorsque la première et la seconde quantité en courant alternatif ont des polarités opposées (ou identiques), un circuit détecteur de niveau (22) ayant un premier et un seconde niveau de détection ($V_{D11}$, $V_{D22}$) et rendant son signal de sortie positif (ou négatif), tout en passant an second niveau de détection, lorsque le signal de sortie du circuit intégrateur atteint le premier niveau de détection ($V_{D11}$), le circuit détecteur de niveau (22) rendant son signal de sortie négatif (ou positif), tout en passant au premier niveau de détection, lorsque le signal de sortie du circuit intégrateur atteint le second niveau de détection ($V_{D22}$), caractérisé en ce qu'il comprend un circuit différenciateur (26) pour faire passer le signal de sortie du circuit intégrateur (20) à une valeur limite supérieure (ou inférieure) au moment où le signal de sortie du circuit détecteur de niveau (22) passe de sa valeur négative à sa valeur positive et pour faire passer le signal de sortie du circuit intégrateur (20) à sa valeur limite inférieure (ou supérieure) au moment où le signal de sortie du circuit détecteur de niveau (22) passe de sa valeur positive à sa valeur négative.

FIG.1.
PRIOR ART

FIG.2.
PRIOR ART

FIG.3.
PRIOR ART

FIG.4.
PRIOR ART

FIG.5.

FIG. 6.
PRIOR ART

FIG. 7.

FIG.8.

FIG.9.

FIG. 10.